(19) Europäisches Patentamt
European Patent Office
Office européen des brevets

(11) EP 0 542 485 B1

(12) **EUROPEAN PATENT SPECIFICATION**

(45) Date of publication and mention of the grant of the patent:
**11.06.1997 Bulletin 1997/24**

(51) Int Cl.[6]: **C08F 2/50**, G03F 7/031, G03F 7/075

(21) Application number: **92310164.6**

(22) Date of filing: **05.11.1992**

(54) **Radiation curable compositions**

Strahlungshärtbare Zusammensetzungen

Compositions durcissables par irradiation

(84) Designated Contracting States:
**BE DE FR GB IT**

(30) Priority: **14.11.1991 GB 9124422**

(43) Date of publication of application:
**19.05.1993 Bulletin 1993/20**

(73) Proprietor: **Dow Corning Limited**
**South Glamorgan CF6 7YL Wales (GB)**

(72) Inventors:
- **Brown, Scott Selby Durrand**
  **Barry, South Glamorgan, Wales (GB)**
- **Lo, Peter Yin Kwai**
  **Midland, Michigan 48640 (US)**
- **Hupfield, Peter Cheshire**
  **Mid Glamorgan, Wales (GB)**

(74) Representative:
**Vandamme, Luc Johan Roger et al**
**Dow Corning Limited**
**Cardiff Road**
**Barry South Glamorgan CF6 7YL Wales (GB)**

(56) References cited:
**EP-A- 0 330 406**

- **CHEMICAL ABSTRACTS, vol. 116, 1992, Columbus, Ohio, US; abstract no. 42176, INOUE, HIROSHI ET AL. 'Crosslinking of cyclotetrasiloxane-containing methacrylate copolymers'**
- **DATABASE WPIL Section Ch, Week 8909, 26 April 1989 Derwent Publications Ltd., London, GB; Class A, AN 064980**
- **DATABASE WPIL Section Ch, Week 9216, 17 June 1992 Derwent Publications Ltd., London, GB; Class A, AN 127856**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

The present invention relates to the use of certain catalysts in radiation curable compositions and to the radiation curable compositions, more specifically those containing vinylether functional materials or organo-silicon compounds, which contain said catalysts.

Radiation curable silicone compositions have been known for some time. They are particularly known in the field of treatment of various materials, including cellulosic substrates for example paper, to provide release coatings. Among compositions proposed for such treatments are compositions comprising organosiloxanes having organo-mercapto groups available for reaction and organosiloxanes having unsaturation, in combination with a photoinitiator. Compositions have been proposed comprising olefinically unsaturated organosiloxanes in which the unsaturation is provided by siloxane units including vinyl, allyl, acryloxy, methacryloxy or cinnamoyloxy groups. Examples of such compositions have been provided in patent specifications G.B. 1 553 586, E.P. 157 540 and G.B. 2 180 547. Epoxyfunctional silicones have been disclosed in G.B. 1 600 613 which may be mixed with a latent catalyst, which could be activated by radiation with Ultra Violet light.

E.P. 105 341 discloses photo-curable vinyloxy-functional polysiloxane resins which have at least one Si-bonded vinyloxy functional group of the formula $H_2C{=}CH{-}O{-}G{-}$, wherein G is alkylene or alkylene interrupted by at least one of a divalent heteroradical selected from -O-, divalent phenylene or substituted divalent phenylene or combinations of such heteroradicals. The specification additionally discloses photopolymerisable compositions which comprise these vinyloxyfunctional polysiloxane resins and catalytic amounts of onium salts having the formula $Q_2I^+MX_n^-$ or $Q_3S^+MX_n^-$ or $Q_3Se^+MX_n^-$ or $Q_4P^+MX_n^-$ or $Q_4N^+MX_n^-$ where Q can be the same of different organic radical, including aromatic carbocyclic and heterocyclic radicals of from 1 to 30 carbon atoms, and $MX_n^-$ is a non-basic, non-nucleophilic anion. European Patent specification 396 130 describes photocurable alkenyloxy-functional organosilicon compounds which have per molecule at least one Si-bonded group of the formula $-(CH_2)_2-R^2-(AR^3)_z-OCH{=}CH{-}CH_2{-}Y'$, wherein A denotes -O-, -S-, or -C(O)O-, $R^2$ denotes a linear or branched alkylene group with 1 to 7 carbon atoms or a cycloalkylene group with 5 to 7 carbon atoms, $R^3$ denotes a linear or branched alkylene group with 2 to 4 carbon atoms, which may be substituted with a hydroxyl, methoxy, ethoxy or trimethyl siloxy group, Y' denotes a hydrogen atom or an alkyl group having 1 to 4 carbon atoms and $\underline{z}$ has a value of 0, 1 or 2. In one of the examples these organosilicon compounds are also cured in the presence of onium salts as described in E.P. 105 341.

Although these onium salts perform reasonably well there is a continuing search for catalysts which are more soluble in non-polar media and are more easily synthesised. Many of the onium salts have counter-ions which cause toxicological concerns, e.g. $AsF_6^-$ and $SbF_6^-$.

We have now found that certain nitrobenzyl derivated catalysts are very useful as photoinitiators in certain radiation curable compositions which comprise alkenylether functional groups, or in radiation-curable organosilicon compounds.

Nitrobenzyl derivatives are known and several of them have been described, together with their preparation method. In Journal of Photopolymer Science and Technology, Volume 3, Nr 3 (1990), pages 259 to 273 there is described the synthesis of several 2-nitrobenzyl esters by reaction of 2,6-dinitrobenzyl alcohol with various sulfonyl chlorides. Materials made had the following general formula

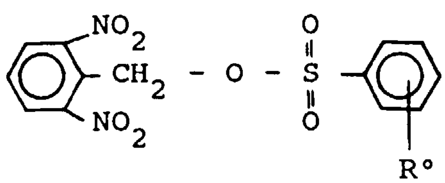

wherein R° is exemplified by $CF_3$, F, di-F, $SO_3$-dinitrobenzyl and $NO_2$. Macromolecules, 1988, 21, pages 2001 to 2006 only deals with 2-nitrobenzyl tosylate, 2,4-dinitrobenzyl tosylate and 2,6-dinitrobenzyl tosylate. Both articles refer to the use of the nitrobenzyl derivatives in the process of lithography and microlithography. The efficiency of these esters as photogenerators of acid was evaluated.

In E.P. specification 330,406 there are disclosed radiation-sensitive resin compositions comprising quinone-diazide-type resins and a compound generating an acid upon irradiation. Said compounds may be nitrobenzyl diethoxyanthracene sulfonate and similar materials. As with the previous two publications, the use of these compositions is for photo resists, in which the acid generating compound is used to depolymerise the polymer resist coating. Nothing in this art suggests that such or similar materials would be useful as photoinitiators for curing (i.e. polymerisation) of compositions.

In Chemical Abstracts 111(12):98434C p-nitrobenzyl-9,10-diethoxyanthracene-2-sulfonate is used as a photocuring catalyst for epoxy resins. However, the radiation is not sufficient to cause hardening of the resin, which is confirmed

by the fact that a post cure for 1 hour at 100°C was necessary to achieve a fully cured resin. There is a need for improved photocuring catalysts, especially for compositions comprising organosilicon compounds or alkenyether functional materials. We have now found that certain o-nitrobenzyl derivatives give improved curing efficiency.

According to the invention there is disclosed the use of nitrobenzyl derivatives of the general formula

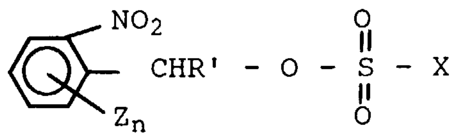 (i)

wherein X denotes an alkyl group, an aryl group, an alkylaryl group, a halogen substituted alkyl, aryl or alkylaryl group, a nitro substituted aryl or alkylaryl group, aryl or alkylaryl group having nitro and halogen substituents or a group $C_6H_4$-$C_6H_4$-$SO_3$-$CHR'C_6H_{4-n}Z_n(NO_2)$, R' denotes hydrogen, methyl, a nitrophenyl or substituted nitrophenyl group, each Z independently denotes a hydrocarbon group, a hydrocarbonoxy group, a group $NO_2$, a halogen atom or an organosilicon compound, provided Z is not an acidic group, n has a value of 0, 1 or 2 as photoinitiators which are used to initiate the polymerisation of radiation curable compositions comprising a dialkenylether or radiation curable organosilocon compound.

The substituent Z in the photoinitiator for use according to the invention may be any hydrocarbon or hydrocarbonoxy group, e.g. alkyl, aryl, alkylaryl, arylalkyl, alkenyl, alkynyl, alkenylaryl, alkoxy, aryloxy or alkenyloxy. Examples of suitable hydrocarbon groups Z include methyl, ethyl, propyl, hexyl, dodecyl, phenyl, tolyl, styryl, ethenyl, methoxy, pentenyloxy, hexenyl and phenylethyl. Preferred hydrocarbon groups are alkyl groups having up to 12, more preferably up to 6 carbon atoms. The nitrobenzyl derivative may alternatively be bonded to an organosilicon compound, for example a siloxane polymer, i.e. where Z is an organosilicon compound. Such organosilicon compound may be any of the known organosilicon compounds provided it does not contain an acid group. Nitrobenzyl derivatives according to the invention wherein Z denotes an organosilicon compound, are materials having at least one silicone unit of the formula

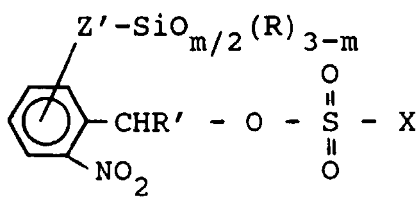 (ii)

wherein R' and X are as defined above, R denotes a monovalent hydrocarbon or hydrocarbonoxy group having up to 18 carbon atoms, Z' denotes an oxygen atom, a divalent alkylene group or an oxyalkylene group and m has a value of from 0 to 3. Preferably the group Z, when an organo-silicon compound is in the meta or para-position in relation to the nitro group. Examples include silanes and siloxanes, although the latter would be preferred. Where Z is an organosiloxane group, the other silicone units, apart from the unit or units of formula (ii), have the general formula

$$SiR_bO_{\frac{4-b}{2}}$$

R is as defined above and b has a value of 0, 1, 2 or 3. Preferably b is 2 for most silicone units, causing the organsiloxane group to be a substantially linear polymer. It may even be possible that two nitrobenzyl derivatives according to the invention are bonded to one organosilicon compound, for example in the $\alpha$,w positions of an organo-polysiloxane. In this case Z could be regarded as a monovalent organosilicon compound for each of the nitrobenzyl derivatives, said monovalent organosilicon compounds being linked together via a siloxane (Si-O-Si) bridge. Such materials may be prepared for example by hydrosilylation of an organosilicon compound having silicon-bonded hydrogen atoms with a nitrobenzyl derivative according to formula (i) in which Z denotes a hydrocarbon group with terminal unsaturation, e.g. a vinyl or allyl group or an oxyalkenyl group. Photoinitiators wherein Z is an organosilicon compound are particularly useful for use with photocurable organosilicon compounds as it improves the compatability of the compounds and the catalyst.

Substituent Z, when present may alternatively be a halogen or a nitro group. Particularly preferred are those photoinitiators where Z is a nitro group present in the alternative ortho position in relation to the -CH= group. There may also be a combination of more than one Z group. Preferably such combination will consist of one organosilicon compound and one nitro group. However, other combinations are also possible.

The group R' is hydrogen or methyl in most cases. It is, however, also possible that R' is a nitrophenyl or substituted nitrophenyl group, preferably halogen or hydrocarbonoxy substituted. The nitro group of said nitrophenyl group has to be in the ortho position in relation to the -CH= group through which it is linked to the rest of the photoinitiator.

The group X may be alkyl, e.g. methyl, ethyl, propyl, hexyl or dodecyl. Preferably the alkyl group has no more than 6 carbon atoms. More preferably X is an aryl or alkaryl group as these are more active as photoinitiators, e.g. phenyl, naphtyl, anthracenyl or tolyl, or substituted aryl or alkaryl groups. Suitable examples are

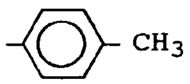, 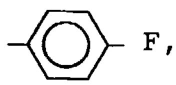, 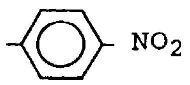, 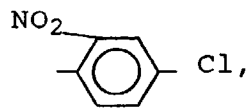,

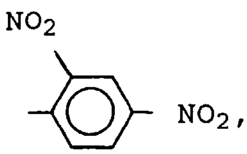, 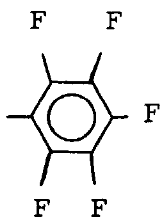 and 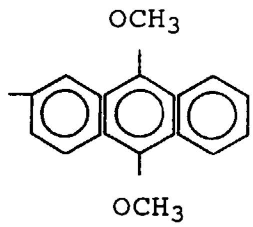

Suitable photocuring catalysts include

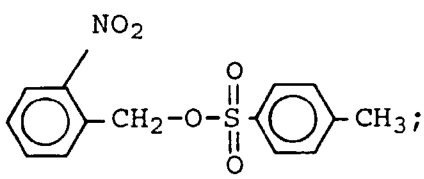; 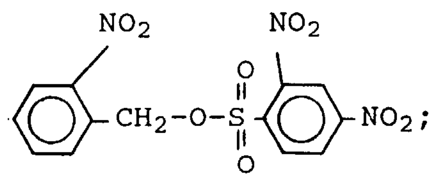;

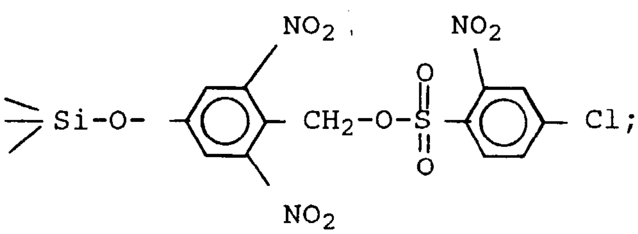; 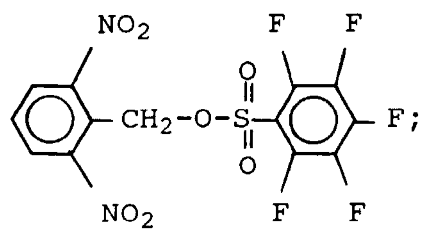;

$$R-(CH_2)_y-(\overset{CH_3}{\underset{CH_3}{Si}}-O)_x-\overset{CH_3}{\underset{CH_3}{Si}}-(CH_2)_y-R$$

wherein

R= 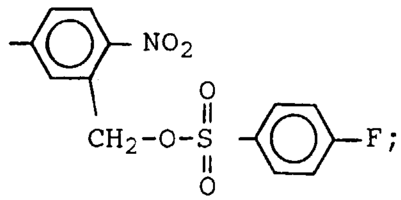

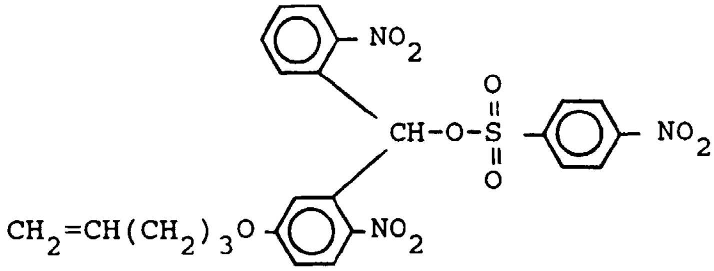

A particularly preferred nitrobenzyl derivative has a value for n equal to 1, while Z denotes a $NO_2$ group and X denotes a nitrophenyl group, wherein the nitro group is in the para position relative to the sulphonic group.

The desired nitro benzyl derivatives can be synthesised via a number of routes. Nitrobenzylalcohols can be reacted directly with various sulphonylchlorides to give the desired nitrobenzylsulphonate ester when the reaction is carried out in the presence of a suitable catalyst. The catalyst used is normally a sterically hindered base, e.g. primary, secondary or tertiary amine.

Alternatively the nitrobenzylalcohol can be reacted with various group (I) metal hydrides (e.g. sodium hydride or potassium hydride) to form the group (I) metal alkoxide. The alkoxide may then be reacted with the sulphonyl halide to produce the corresponding nitrobenzylsulphonate ester and the group (I) metal halide salt which is easily removed by filtration. A similar procedure uses various organolithium reagents. For example, butyl lithium may be reacted with the nitrobenzylalcohol to form the lithium alkoxide salt which is then reacted with the sulphonyl-halide as described above.

It is also possible to react the nitrobenzylalcohol with various organomagnesium compounds. The Grignard reagent produced in this way reacts with the sulphonyl halide to produce the desired nitrobenzylsulphonate ester and magnesium halide which can easily be removed by filtration.

The nitrobenzylalcohol may also be reacted with various acid anhydrides which have been formed from the corresponding sulphonyl chlorides and/or sulphonic acids. Again, this reaction may be catalysed by adding an appropriate hindered base.

In yet another way the desired nitrobenzylsulphonate esters can be synthesised from the reaction of nitrobenzylchloride (halide) with the metal salt of the sulphonic acid, e.g. silver sulphonate or barium sulphonate. Preparation of the preferred nitrobenzyl derivative may be via the reaction of nitrotosylchloride with dinitrobenzyl-alcohol in the presence of a hindered base, e.g. dicyclohexylamine.

According to another aspect of the present invention there is provided a radiation curable composition comprising (A) a radiation curable compound and (B) a catalytic amount of a nitrobenzyl derivative to initiate polymerisation of (A) as described above. The radiation curable compound (A) is selected from dialkenylethers (A') and radiation curable organsilicon compounds (A").

The radiation curable dialkenylethers (A') have the general formula

$$R''CH=CH\text{-}O\text{-}Y\text{-}OCH=CHR'' \qquad \text{(iii)}$$

wherein Y denotes a divalent hydrocarbon, hydrocarbonoxy or polyoxyalkylene group and R" denotes a monovalent alkyl group having up to 10 carbon atoms or a hydrogen atom. Suitable dialkenylethers include $CH_2=CH(OCH_2CH_2)_3OCH=CH_2$ and

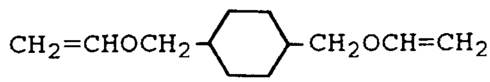

More preferred for the purposes of this invention are radiation curable organosilicon compounds (A"). They may be organosilicon compounds having at least two of vinyl, allyl, acryloxy, methacryloxy, cinnamoyloxy or epoxy groups subsituted directly or indirectly onto a silicon atom. Particularly preferred however are organo-silicon compounds having alkenylethers substituents.

According to another aspect of the present invention there is provided a radiation curable composition comprising (A") an organosilicon compound having at least two silicon-bonded groups per molecule of the general formula -Y-O-CH=CHR" wherein Y denotes a divalent hydrocarbon, hydrocarbonoxy or polyoxyalkylene group and R" denotes a hydrogen atom or an alkyl group having up to 10 carbon atoms and (B) a catalytic amount of an o-nitrobenzyl derivative of the general formula

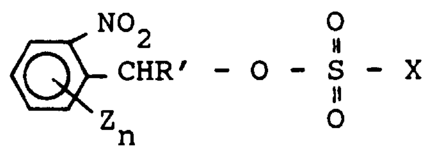 (i)

wherein X denotes an alkyl group, an aryl group, an alkylaryl group, a halogen substituted alkyl, aryl or alkylaryl group, a nitro substituted aryl or alkylaryl group, an aryl or alkylaryl group having nitro and halogen substituents or a group $C_6H_4$-$C_6H_4$-$SO_3$-CHR'$C_6H_{4-n}Z_n(NO_2)$, R' denotes hydrogen, methyl, a nitrophenyl or substituted nitrophenyl group, each Z independently denotes a hydrocarbon group, a hydryocarbonoxy group, a group $NO_2$, a halogen atom or an organosilicon compound, provided Z is not an acidic group, $\underline{n}$ has a value of 0, 1 or 2.

The organosilicon compound (A") may be a silane or a siloxane. Where the compound is a silane, it would have the general formula

$$R_aSi(Y\text{-}O\text{-}CH{=}CHR'')_{4-a} \qquad \text{(iv)}$$

wherein R denotes a monovalent hydrocarbon or hydrocarbonoxy group having up to 18 carbon atoms, R" denotes a hydrogen atom of a monovalent alkyl group having up to 10 carbon atoms, Y denotes a divalent hydrocarbon, hydrocarbonoxy or polyoxyalkylene group and $\underline{a}$ has a value of from 0 to 2, preferably 2.

Where the organosilicon compound (A") is a siloxane, it would have at least one unit of the general formula

$$R_cSi(Y\text{-}O\text{-}CH{=}CHR'')_dO_{\frac{4-d-c}{2}} \qquad \text{(v)}$$

wherein R, R" and Y are as defined above, $\underline{d}$ has a value of 1, 2 or 3, $\underline{c}$ has a value of 0, 1 or 2 and $\underline{c+d}$ has a value of from 1 to 3, any other siloxane unit present having the general formula

$$R_bSiO_{\frac{4-b}{2}} \qquad \text{(vi)}$$

wherein $\underline{b}$ has a value of from 0 to 3. Preferably a siloxane (A") has at least two units of the general formula (v) with the value of $\underline{d}$ being 1. It is preferred that compound (A") is an organopolysiloxane, most preferably a linear or substantially linear polymer, wherein the majority of the siloxane units have the formula (vi), with the value of $\underline{b}$ equal to 2. The viscosity of such siloxanes may range from 10 to 10 x $10^6$ mPa.s but preferably is in the range of from 100 to 10,000 mPa.s, more preferably 150 to 2500 mPa.s. It is also preferred that 80% of all substituents R in the units of the formula (vi) are lower alkyl or aryl groups, e.g. alkyl having from 1 to 4 carbon atoms or phenyl groups, particularly preferred are methyl or ethyl groups. More preferably substantially all the R groups in the units (vi) are methyl groups.

Silanes which are suitable as component (A") in compositions according to the invention may be made e.g. by hydrosilylation of silanes of the formula $R_aSiH_{4-a}$, wherein R and $\underline{a}$ are as described above with a compound having both a vinyl and an allyl group. Similar hydrosilylation reactions have been described in the literature, and more specifically in E.P. 105 341. Alternatively the method of E.P. 396 130 may be used, which requires a hydrosilylation reaction between a compound of the formula $CH_2$=CH-$R^2$-$(AR^3)_z$-$OCH_2$-CH=CH-R with an organosilicon compound having at least one Si-bonded hydrogen atom in the presence of a hydrosilylation catalyst, followed by a second step which effects the transfer of the carbon-carbon double bond to the carbon bonds neighbouring the ether oxygen by heating the compound in the presence of an appropriate catalyst, e.g. Ruthenium complexes having phosphine ligands. A, $R^2$, $R^3$, R and z herein are as defined in the prior art description of E.P. 396 130. Yet another method of making suitable silanes for the compositions of this invention is the reaction of e.g. hydroxyalkyl alkenylethers with alkoxy silanes (transalkoxylation) or the reaction with acetamido functional silanes, as is described in our copending application (G. B. 9124247.9). According to that invention there is provided a method of making organosilicon compounds according to the first aspect of the invention by a process which comprises reacting together a reagent organosilicon compound having at least one silicon-bonded group A, wherein A denotes a group -OR" or a group -N(R")-C(O)-R", compound of the general formula HO/OCH=CHR" wherein R" and Y are as defined above. Both E.P. 105 341 and E.P. 396 130 are hereby included by reference.

Siloxanes which are suitable as component (A") in compositions according to the present invention may be made either by the hydrolysis and polymerisation or the cohydrolysis and polymerisation of silanes as mentioned above with suitable other silanes, short chain siloxanes or cyclic siloxanes, as is known in the art of making siloxanes. Alternatively, and more preferably, the suitable siloxanes would be made either by the hydrosilylation and where required the isomerisation of siloxanes having silicon-bonded hydrogen atoms according to methods described above and referenced in E.P. 105 341 and E.P. 396 130 or by the reaction of hydroxyalkyl vinylethers with appropriate siloxanes e.g. those having alkoxy groups or acetamido groups linked to some silicon atoms, as described in our copending application (G. B. 9124247.9)

The radiation curable compositions according to the invention are crosslinkable materials which can form an elastomeric or resinous film or composition upon exposure to radiation. They are particularly useful when applied to a substrate as a thin coating and are caused to crosslink by exposing the coated substrate to ultraviolet radiation, as their cure rate in such systems is very fast. Thus they are particularly useful in compositions for the formation of release coatings on cellulosic or other substrates e.g. paper, polyester film and polyethylene, which may be used in the production of non-stick surfaces for food contact, packaging or as coatings which release pressure sensitive adhesives, for example as applied to labels and laminates. Another area where such compounds may advantageously be used is conformal coating e.g. in electronic applications.

The invention accordingly also includes a method of treating a substrate by applying thereto a composition according to the invention and exposing said composition to radiation.

Radiation which may cause the composition to cure varies from very high energy radiation to lower energy radiation, but is preferably radiation in the ultra violet range. UV radiation is preferred as it provides the best combination of convenience, economy, efficiency and safety for a fast curing composition. While UV radiation in the range of wavelengths of from 190 to 350nm is preferred, the use of sensitisers may allow a widening of efficient wavelengths into the visible light. Suitable sensitisers are well known in the art and have been described in great detail in numerous publications. They include as the most well known material benzophenone. Curing rate of the compositions according to the invention when exposed to radiation is fast. In most applications a composition coated as a thin film will cure to an elastomeric of resinous material in less than 30 minutes, more typically, in less than 5 minutes. It may be as quick as 1 to 30 seconds. Upon exposure to radiation the film will be tackfree in an even shorter time.

The nitrobenzyl derivative photoinitiators may be present in any proportions which will effect curing of the composition. As with any catalytic system it is preferred to minimise the amount of photoinitiators used as much as possible. We have found that efficient amounts of photoinitiator tend to be in the range of from 0.5 to 10% by weight based on the weight of the organosilicon compound, preferably 1 to 5%. The photoinitiator may be introduced into the composition by mere mixing of the initiator with the organosilicon compounds. After exposure to radiation the composition will then cure to an elastomeric or resinous material.

Compositions according to the invention may also comprise a number of other ingredients. Optional additional ingredients include photosensitisers as mentioned above, fillers, high release additives, e.g. vinylated silicone resins, photochromic materials, dyes, colorants, preservatives, fragrances etc. Most importantly, however, other radiation curable compounds may be included in the composition. In preferred compositions where (A") is an alkenylether functional siloxane, examples of such other radiation curable compounds are epoxy functional siloxanes as have been disclosed for example in G.B. patent application 1 600 613. Such materials will affect the cure rate of the composition and the physical characteristics of the finished cured product. Other ingredients as mentioned herein may be present in any amount provided they do not inhibit the curing ability of the composition. Preferably, however, such ingredients, in particular any epoxy functional siloxanes which may be present, should not exceed 40% by weight of the combined weight of the organosilicon compound and such ingredient. Most preferably no more than 25% by weight should be occupied by said other ingredients.

Curing itself may be achieved in any of the known ways including passing a coated substrate under a UV lamp at

a predetermined rate and exposing a complete coated substrate to radiation by switching on the required energy source for a predetermined time.

Also included in the scope of the invention are substrates which have been coated with a release coating resulting from coating the substrate with a composition according to the invention and curing the composition by exposure to radiation.

There now follow a number of examples to illustrate the invention. All parts and percentages are by weight unless otherwise stated and Me denotes a methyl group.

Example 1

5.9 mmole of 4-nitrotosylchloride and 5.35 mmole of 2,6- dinitrobenzyl alcohol were mixed together in $20cm^3$ of dry acetone, followed by the dropwise addition of 5.5 mmole of dicyclohexylamine. The resulting mixture was stirred for 12 hours after which time a precipitate was formed which was removed by filtration. The solvent was removed from the filtrate under reduced pressure to yield a crude product, which was subsequently recrystallised from a chloroform-dichloromethane mixture, yielding 2,6-dinitrobenzyl nitrotosylate.

0.684 mole of N-methylacetamide was melted and transferred to a round bottomed flask which was equipped with a magnetic stirrer bar and reflux condenser. 100ml of toluene was added together with 0.684 moles of sodium metal. A slow evolution of hydrogen was observed. The mixture was heated to reflux under a nitrogen blanket. When all the sodium had been consumed the reaction mixture was allowed to cool, filtered, washed with toluene and dried under reduced pressure. This gave the sodium salt of N-methylacetamide, of which 0.28 mole was stirred as a suspension in 100ml of toluene under a nitrogen blanket at ambient temperature. 0.126 mole of methylvinyldichlorosilane was added dropwise to the reaction mixture. Solid sodium chloride was removed by filtration after a 3 hour reaction. Toluene was also removed leaving a pale yellow liquid which was characterised by nuclear magnetic resonance spectroscopy as bis(N-methylacetamido)methylvinylsilane. 0.0987 mole of this silane was dissolved in 100ml of toluene and 0.197 mole of 4-ethenyloxy-1-butanol was added dropwise to the solution. An exothermic reaction was observed. After 2 hours N-methyl-acetamide was removed by distillation, giving a clear colourless liquid, which was characterised by gas chromatography, mass spectroscopy and nuclear magnetic resonance spectroscopy as bis[4-(ethenyloxy)-1-butanoxy] methylvinylsilane.

A few crystals of the 2,6-dinitrobenzyl nitrotosylate were added to 2 $cm^3$ of bis[4-(ethenyloxy)-1-butanoxy] methylvinylsilane in a quartz tube. The mixture was agitated until the ester had completely dissolved to give a clear colourless solution. The solution was then irradiated with UV light from a medium pressure mercury lamp. A hard glassy material was obtained after only 3 minutes of exposure. The reaction proceeded quickly without the exclusion of oxygen.

Example 2

2-nitrobenzyl alcohol (0.01 mole) was added to dry acetone (10ml) containing tolyl sulphonyl chloride (0.011 mole). To this was added dicyclohexylamine (0.01 mole) in dry acetone (2ml). The reaction mixture was then stirred under nitrogen at room temperature, until the reaction was complete as evidenced by thin layer chromatography. The reaction mixture was then filtered and the precipitate washed three times with dry acetone. The washings were combined with the filtrate and the acetone removed using a rotary evaporator. The residue was then dissolved in a $CCl_4/CHCl_3$ mixture (3:1) and the product precipitated by the additon of hexane whilst cooling. The product purity was checked by thin layer chromatography, and if required the material was again recrystallised. A 69% yield of tan crystals was obtained and the product identified as the nitrobenzyl tolyl sulphonate ester using NMR spectroscopy.

Example 3

Synthesis of siloxane bound nitrobenzyl sulphonate esters.

Step 1

5-pentenyloxy-2-nitro-benzaldehyde was prepared by taking 2-nitro-5-hydroxy-benzaldehyde (0.1 mole) and reacting it with 5-bromopentene (0.11 mole) in the presence of potassium carbonate (0.11 mole) in aceto nitrile under reflux. After the reaction was complete as evidenced by thin layer chromatography, the material was purified by flash chromatography (Hexane:ethyl acetate 9:1). Evaporation of the solvent gave a viscous yellow/brown oil identified as the desired product. Yield > 90%.

Step 2

To 5-pentenyloxynitrobenzaldehyde (50 mmoles) in methanol (75ml) was added sodium borohydride (30 mmoles) dissolved in 16 ml of 0.2N NaOH, at room temperature. The methanol was then removed under vacuum once the reaction was complete and the water residue extracted several times with ether. The ether washings were then dried over anhydrous magnesium sulphate and filtered. After removal of solvents the material was purified using flash chromatography to give an orange oil which was shown to be the desired 5-pentenyloxy nitrobenzylalcohol. Yield > 85%.

Step 3

To 5-pentenyloxy-2-nitro-benzyl alcohol (80 mmoles) in 10ml of dry toluene was added at reflux a SiH-endblocked siloxane copolymer (Dp of 10 containing 80 mmoles of SiH). The toluene solution contained $10^{-5}$ moles of a Pt catalyst per mole of SiH. The mixture was kept at reflux until disappearance of the SiH stretch at approximately 2100 $cm^{-1}$ was observed. The toluene was then stripped under vacuum to give a viscous yellow brown oil, after purification using flash chromatography. Yield 95% NMR spectroscopy showed that addition of the 5-pentenyloxy-2-nitro-benzyl alcohol had taken place cleanly to give an end-blocked 5-pentenyloxy-2-nitro-benzyl alcohol functional siloxane polymer.

Step 4

To the end-blocked 5-pentenyloxy-2-nitro-benzyl alcohol functional siloxane polymer (80 mmoles) was added 4-nitrobenzene sulphonyl chloride (80 mmoles) in dry acetone (10ml). To this was added dicyclohexylamine (80 mmoles) dissolved in dry acetone (2ml). This was left for three hours at room temperature upon which it was filtered. The acetone was then removed under vacuum. The residue was then dissolved in a small amount of hexane and filtered. This was repeated three times. Finally the residue dissolved in hexane was washed twice with 0.01M HCl solution and dried over anhydrous magnesium sulphate. Removal of the hexane gave a product consistent with the desired polymer bound sulphonate ester.

Examples 4 to 15

Using similar methods to the one described in Example 2 and 3 the following compounds were prepared:

(4) 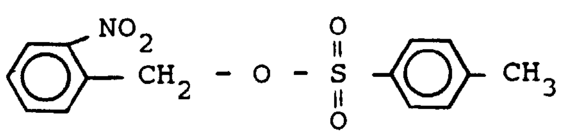 Yield 69%

(5) 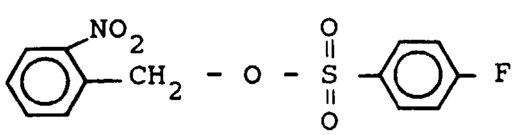 Yield 56%

(6) 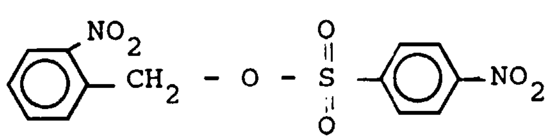 Yield 58%

(7) 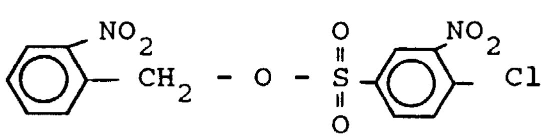 Yield 65%

(8) 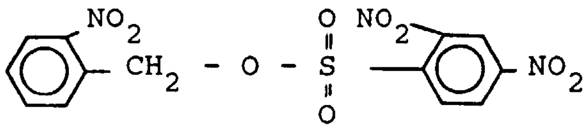 Yield 36%

(9) 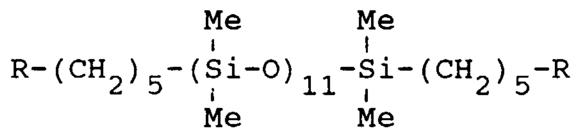

wherein

R = 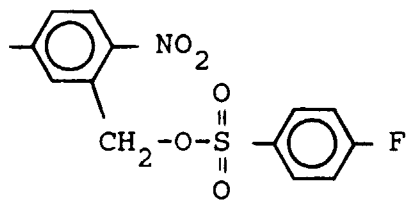

(10) 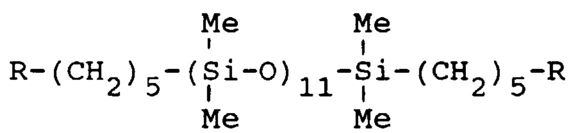

wherein

R = 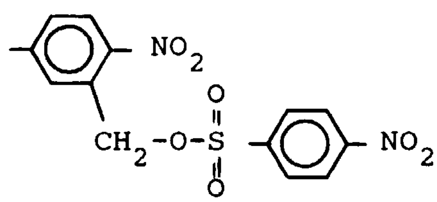

(11) 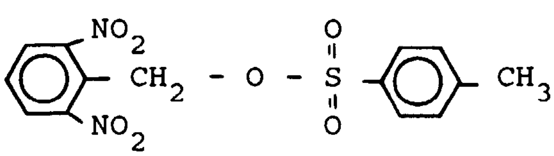 Yield 71%

(12) 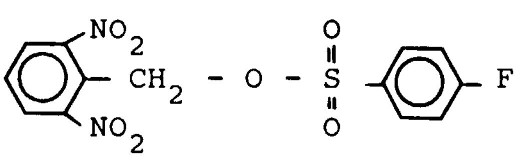 Yield 65%

(13) 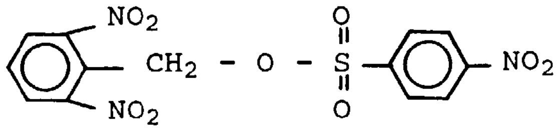 Yield 55%

(14) 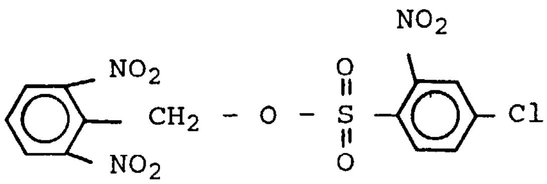 Yield 68%

(15) 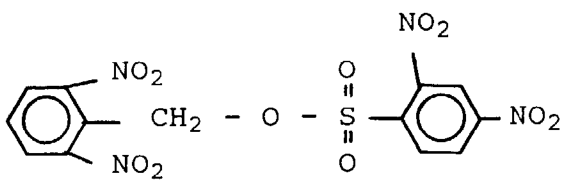 Yield 30%

(16) 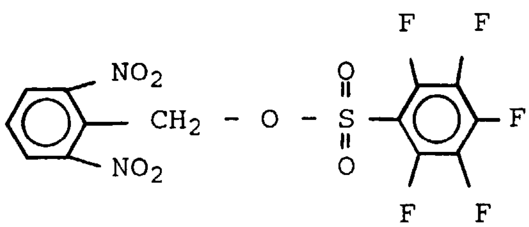 Yield 20%

Examples 17 to 27

A mixture of $CH_2$=$CH(OCH_2CH)_3OCH$=$CH_2$ (DVE-3) and photoinitiator from previous examples at a concentration of 0.03 moles of catalyst per kg of DVE-3 was prepared. The mixture was coated onto a paper or polyester surface with a coating weight of 1g/$m^2$ passed under 2 H-bulbs with 125 watts/2,54cm focussed power. The cure speed was calculated from the time taken to produce a cured film. Results are given in Table I.

Table I

| Example | Photoinitiator Example | Cure Speed (m/min) |
|---|---|---|
| 17 | 4 | 3.96 |
| 18 | 5 | 8.53 |
| 19 | 6 | 10.67 |
| 20 | 7 | 18.29 |
| 21 | 8 | 33.53 |
| 22 | 11 | 5.49 |
| 23 | 12 | 18.29 |
| 24 | 13 | 29.87 |
| 25 | 14 | 56.69 |
| 26 | 15 | 76.20 |
| 27 | 16 | 97.54 |

Example 28

The procedure of Example 25 was repeated, apart from the fact that DVE-3 was replaced with

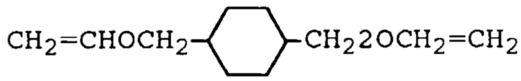

the resulting cure speed was 42.67 m/min.

Examples 29 to 30

The procedure of Example 28 was followed, with the following changes instead of the organic polymer, a siloxane having a degree of polymerisation of 24 and 4 mole % silicon-bonded vinylether groups $-O(CH_2)_4OCH=CH_2$ and 5% by weight of the photoinitiator of Examples 9 and 10 were used respectively.

The cure speeds determined were 18.29 m/min and 23.77 m/min respectively. This is more than twice the cure speed of the corresponding photoinitiators which are not siloxane bound (examples 18 and 19).

Example 31

5 parts by weight of the photoinitiator of Example 9 were mixed with 95 parts of a trimethyl silyl endblocked polydimethylsiloxane having a degree of polymerisation of 200 and 5 mole % epoxy groups

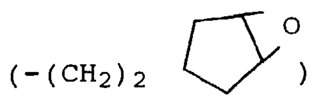

The composition was coated and cured as described for Example 31 and a cure speed of 2.44 m/min was found.

**Claims**

1. The use of nitrobenzyl derivatives of the general formula

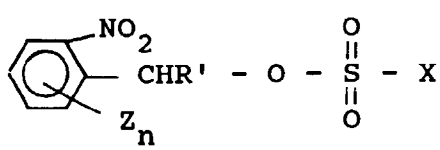 (i)

wherein X denotes an alkyl group, an aryl group, an alkylaryl group, a halogen substituted alkyl, aryl or alkylaryl group, a nitro substituted aryl or alkylaryl group, an aryl or alkylaryl group having nitro and halogen substituents or a group $C_6H_4$-$C_6H_4$-$SO_3$-$CHR'C_6H_{4-n}Z_n(NO_2)$, R' denotes hydrogen, methyl, a nitrophenyl or substituted nitrophenyl group, each Z independently denotes a hydrocarbon group, a hydrocarbonoxy group, a group $NO_2$, a halogen atom or an organosilicon compound provided Z is not an acidic group and n has a value of 0, 1 or 2 as photoinitiators characterised in that they are used to initiate the polymerisation of radiation curable compositions comprising a dialkenylether or radiation curable organosilicon compound.

2. The use of a nitrobenzyl derivative according to Claim 1 characterised in that at least one of the Z-groups of the nitrobenzyl derivative denotes an organosilicon group.

3. A radiation curable composition comprising (A) a radiation curable compound and (B) a catalytic amount of a nitrobenzyl derivative to initiate polymerisation of (A) characterised in that (A) is a dialkenylether or an organosilicon compound and in that the nitrobenzyl derivative is an o-nitrobenzyl derivative of the general formula

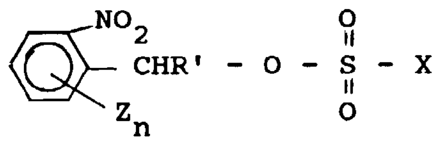 (i)

wherein X denotes an alkyl group, an aryl group, an alkylaryl group, a halogen substituted alkyl, aryl or alkylaryl group, a nitro substituted aryl or alkylaryl group, an aryl or alkylaryl group having nitro and halogen substituents or a group $C_6H_4$-$C_6H_4$-$SO_3$-CHR'$C_6H_{4-n}Z_n(NO_2)$, R' denotes hydrogen, methyl, a nitrophenyl or substituted nitrophenyl group, each Z independently denotes a hydrocarbon group, a hydrocarbonoxy group, a group $NO_2$, a halogen atom or an organosilicon compound provided Z is not an acidic group and n has a value of 0, 1 or 2.

**4.** A radiation curable composition according to Claim 3 further characterised in that the radiation curable compound is a dialkenylether (A') having the general formula R"CH=CH-O-Y-O-CH=CHR" (iii), wherein Y denotes a divalent hydrocarbon, hydrocarbonoxy or polyoxyalkylene group and R" denotes a monovalent alkyl group having up to 10 carbon atoms or a hydrogen atom.

**5.** A radiation curable compcsition according to Claim 3 further characterised in that the radiation curable compound is an organosilicon compound (A") having at least two silicon-bonded groups per molecule of the general formula -Y-O-CH=CHR", wherein Y denotes a divalent hydrocarbon, hydrocarbonoxy or polyoxyalkylene group and R" denotes a hydrogen atom or an alkyl group having up to 10 carbon atoms.

**6.** A radiation curable composition according to Claim 5 further characterised in that the organosilicon compound (A") is a silane having the general formula

$$R_aSi(Y\text{-}O\text{-}CH{=}CHR'')_{4-a} \qquad \text{(iv)}$$

wherein R denotes a monovalent hydrocarbon or hydrocarbonoxy group having up to 18 carbon atoms, R" denotes a hydrogen atom of a monovalent alkyl group having up to 10 carbon atoms, Y denotes a divalent hydrocarbon, hydrocarbonoxy or polyoxyalkylene group and a has a value of from 0 to 2.

**7.** A radiation curable composition according to Claim 5 further characterised in that the organosilicon compound (A") is a siloxane having at least one unit of the general formula

$$R_cSi(Y\text{-}O\text{-}CH{=}CHR'')_dO_{\frac{4-d-c}{2}} \qquad \text{(v)}$$

wherein R, R" and Y are as defined above, d has a value of 1, 2 or 3, c has a value of 0, 1 or 2 and c+d has a value of from 1 to 3, any other siloxane unit present having the general formula

$$R_bSiO_{\frac{4-b}{2}} \qquad \text{(vi)}$$

wherein b has a value of from 0 to 3.

**8.** A radiation curable composition according to Claim 7 further characterised in that siloxane (A") has at least two units of the general formula (v) with the value of d being 1, is a substantially linear organopolysiloxane, wherein the majority of the siloxane units have the formula (vi) with the value of b equal to 2.

**9.** A radiation curable composition according to any one of Claims 3 to 8 further characterised in that the amount of catalyst used is in the range of from 0.5 to 10% by weight based on the weight of the compound (A).

**10.** A method of treating a substrate characterised in that it comprises applying to the substrate a composition according to any one of Claims 3 to 9 and curing the composition by exposing the treated substrate to radiation.

11. A substrate which has been treated with a composition according to any one of Claims 3 to 9.

**Patentansprüche**

1. Verwendung von Nitrobenzylderivaten der allgemeinen Formel

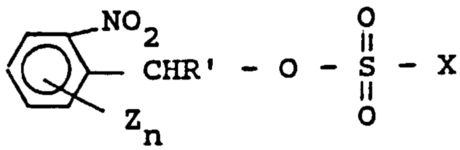

(i)

worin X eine Alkylgruppe, eine Arylgruppe, eine Alkylarylgruppe, eine halogensubstituierte Alkyl-, Aryl- oder Alkylarylgruppe, eine nitrosubstituierte Aryl- oder Alkylarylgruppe, eine Aryl- oder Alkylarylgruppe mit Nitro- und Halogensubstituenten oder eine Gruppe $C_6H_4$-$C_6H_4$-$SO_3$-CHR'$C_6H_{4-n}Z_n(NO_2)$ bedeutet, R' Wasserstoff, eine Methyl-, Nitrophenyl- oder substituierte Nitrophenylgruppe bedeutet, jeder Rest Z unabhängig eine Kohlenwasserstoffgruppe, eine Hydrocarbonoxygruppe, eine Gruppe $NO_2$, ein Halogenatom oder eine Organosiliciumverbindung bedeutet, mit dem Vorbehalt, daß Z keine saure Gruppe ist, und n einen Wert von 0, 1 oder 2 hat, als Photoinitiatoren, dadurch gekennzeichnet, daß sie dazu verwendet werden, um die Polymerisation von durch Strahlung härtbaren Zusammensetzungen, die einen Dialkenylether oder eine durch Strahlung härtbare Organosiliciumverbindung umfassen, zu starten.

2. Verwendung eines Nitrobenzylderivats nach Anspruch 1, dadurch gekennzeichnet, daß mindestens eine der Gruppen Z des Nitrobenzylderivats eine Organosiliciumgruppe bedeutet.

3. Durch Strahlung härtbare Zusammensetzung, umfassend (A) eine durch Strahlung härtbare Verbindung und (B) eine katalytische Menge eines Nitrobenzylderivats, um die Polymerisation von (A) zu starten, dadurch gekennzeichnet, daß (A) ein Dialkenylether oder eine Organosiliciumverbindung ist und daß das Nitrobenzylderivat ein o-Nitrobenzylderivat der allgemeinen Formel

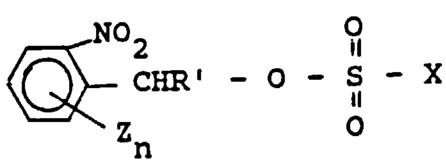

(i)

ist, worin X eine Alkylgruppe, eine Arylgruppe, eine Alkylarylgruppe, eine halogensubstituierte Alkyl-, Aryl- oder Alkylarylgruppe, eine nitrosubstituierte Aryl- oder Alkylarylgruppe, eine Aryl- oder Alkylarylgruppe mit Nitro- und Halogensubstituenten oder eine Gruppe $C_6H_4$-$C_6H_4$-$SO_3$-CHR'$C_6H_{4-n}Z_n(NO_2)$ bedeutet, R' Wasserstoff, eine Methyl-, Nitrophenyl- oder substituierte Nitrophenylgruppe bedeutet, jeder Rest Z unabhängig eine Kohlenwasserstoffgruppe, eine Hydrocarbonoxygruppe, eine Gruppe $NO_2$, ein Halogenatom oder eine Organosiliciumverbindung bedeutet, mit dem Vorbehalt, daß Z keine saure Gruppe ist, und n einen Wert von 0, 1 oder 2 hat.

4. Durch Strahlung härtbare Zusammensetzung nach Anspruch 3, weiter dadurch gekennzeichnet, daß die durch Strahlung härtbare Verbindung ein Dialkenylether (A') der allgemeinen Formel R"CH=CH-O-Y-O-CH=CHR" (iii) ist, worin Y eine divalente Kohlenwasserstoff-, Hydrocarbonoxy- oder Polyoxyalkylengruppe bedeutet und R" eine monovalente Alkylgruppe mit bis zu 10 Kohlenstoffatomen oder ein Wasserstoffatom bedeutet.

5. Durch Strahlung härtbare Zusammensetzung nach Anspruch 3, weiter dadurch gekennzeichnet, daß die durch Strahlung härtbare Verbindung eine Organosiliciumverbindung (A") ist mit mindestens zwei siliciumgebundenen Gruppen der allgemeinen Formel -Y-O-CH=CHR", worin Y eine divalente Kohlenwasserstoff-, Hydrocarbonoxy- oder Polyoxyalkylengruppe bedeutet und R" ein Wasserstoffatom oder eine Alkylgruppe mit bis zu 10 Kohlenstoffatomen bedeutet, im Molekül.

6. Durch Strahlung härtbare Zusammensetzung nach Anspruch 5, weiter dadurch gekennzeichnet, daß die Organosiliciumverbindung (A") ein Silan der allgemeinen Formel

$$R_aSi(Y\text{-}O\text{-}CH{=}CHR")_{4-a} \qquad \text{(iv)}$$

ist, worin R eine monovalente Kohlenwasserstoff- oder Hydrocarbonoxygruppe mit bis zu 18 Kohlenstoffatomen bedeutet, R" ein Wasserstoffatom oder eine monovalente Alkylgruppe mit bis zu 10 Kohlenstoffatomen bedeutet, Y eine divalente Kohlenwasserstoff-, Hydrocarbonoxy- oder Polyoxyalkylengruppe bedeutet und a einen Wert von 0 bis 2 hat.

**7.** Durch Strahlung härtbare Zusammensetzung nach Anspruch 5, weiter dadurch gekennzeichnet, daß die Organosiliciumverbindung (A") ein Siloxan mit mindestens einer Einheit der allgemeinen Formel

$$R_cSi(Y\text{-}O\text{-}CH{=}CHR")_dO_{\frac{4-d-c}{2}} \qquad \text{(v)}$$

ist, worin R, R" und Y wie oben definiert sind, d einen Wert von 1, 2 oder 3 hat, c einen Wert von 0, 1 oder 2 hat und c+d einen Wert von 1 bis 3 hat, wobei jede weitere vorhandene Siloxaneinheit die allgemeine Formel

$$R_bSiO_{\frac{4-b}{2}} \qquad \text{(vi)}$$

hat, worin b einen Wert von 0 bis 3 hat.

**8.** Durch Strahlung härtbare Zusammensetzung nach Anspruch 7, weiter dadurch gekennzeichnet, daß das Siloxan (A") mindestens zwei Einheiten der allgemeinen Formel (v) hat, wobei der Wert von d 1 ist, daß das Siloxan ein im wesentlichen lineares Organopolysiloxan ist, worin die Mehrzahl der Siloxaneinheiten die Formel (vi) haben, wobei der Wert von b gleich 2 ist.

**9.** Durch Strahlung härtbare Zusammensetzung nach einem der Ansprüche 3 bis 8, weiter dadurch gekennzeichnet, daß die verwendete Katalysatormenge in einem Bereich von 0,5 bis 10 Gew.-%, bezogen auf das Gewicht der Verbindung (A), liegt.

**10.** Verfahren zur Behandlung eines Substrats, dadurch gekennzeichnet, daß es umfaßt, daß man auf das Substrat eine Zusammensetzung nach einem der Ansprüche 3 bis 9 aufträgt und die Zusammensetzung härtet, indem das behandelte Substrat bestrahlt wird.

**11.** Substrat, das mit einer Zusammensetzung nach einem der Ansprüche 3 bis 9 behandelt wurde.

## Revendications

**1.** Utilisation de dérivés nitrobenzylés de la formule générale

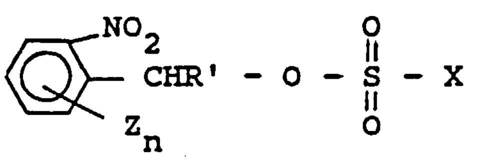

(i)

dans laquelle X représente un groupe alkyle, un groupe aryle, un groupe alkylaryle, un groupe alkyle, aryle ou alkylaryle substitué par un halogène, un groupe aryle ou alkylaryle substitué par un groupe nitro, un groupe aryle ou alkylaryle ayant des substituants nitro et halogène ou un groupe $C_6H_4\text{-}C_6H_4\text{-}SO_3\text{-}CHR'C_6H_{4-n}Z_n(NO_2)$, R' représente un hydrogène, un groupe méthyle, un groupe nitrophényle ou nitrophényle substitué, chaque Z représente indépendamment un groupe hydrocarboné, un groupe hydrocarbonoxy, un groupe $NO_2$, un atome d'halogène ou

un composé organosilicié à condition que Z ne soit pas un groupe acide, et n a une valeur de 0, 1 ou 2, en tant que photoinitiateurs, caractérisée en ce qu'ils sont utilisés pour initier la polymérisation de compositions durcissables par une radiation comprenant un éther de dialcényle ou un composé organosilicié durcissable par une radiation.

2. Utilisation d'un dérivé nitrobenzylé selon la revendication 1, caractérisée en ce qu'au moins l'un des groupes Z du dérivé nitrobenzylé représente un groupe organosilicié.

3. Composition durcissable par une radiation, comprenant (A) un composé durcissable par une radiation et (B) une quantité catalytique d'un dérivé nitrobenzylé pour initier la polymérisation de (A), caractérisée en ce que (A) est un éther de dialcényle ou un composé organosilicié et en ce que le dérivé nitrobenzylé est un dérivé o-nitrobenzylé de la formule générale

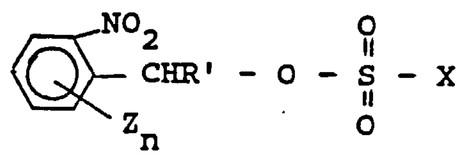

(i)

dans laquelle X représente un groupe alkyle, un groupe aryle, un groupe alkylaryle, un groupe alkyle, aryle ou alkylaryle substitué par un halogène, un groupe aryle ou alkylaryle substitué par un groupe nitro, un groupe aryle ou alkylaryle ayant des substituants nitro et halogène ou un groupe $C_6H_4$-$C_6H_4$-$SO_3$-CHR'$C_6H_{4-n}Z_n(NO_2)$, R' représente un hydrogène, un groupe méthyle, un groupe nitrophényle ou nitrophényle substitué, chaque Z représente indépendamment un groupe hydrocarboné, un groupe hydrocarbonoxy, un groupe $NO_2$, un atome d'halogène ou un composé organosilicié à condition que Z ne soit pas un groupe acide, et n a une valeur de 0, 1 ou 2.

4. Composition durcissable par une radiation selon la revendication 3, caractérisée en outre en ce que le composé durcissable par une radiation est un éther de dialcényle (A') ayant la formule générale R"CH=CH-O-Y-O-CH=CHR" (iii), où Y représente un groupe hydrocarboné, hydrocarbonoxy ou polyoxyalkylène divalent et R" représente un groupe alkyle monovalent ayant jusqu'à 10 atomes de carbone, ou un atome d'hydrogène.

5. Composition durcissable par une radiation selon la revendication 3, caractérisée en outre en ce que le composé durcissable par une radiation est un composé organosilicié (A") ayant au moins deux groupes liés au silicium par molécule de la formule générale -Y-O-CH=CHR", où Y représente un groupe hydrocarboné, hydrocarbonoxy ou polyoxyalkylène divalent et R" représente un atome d'hydrogène ou un groupe alkyle ayant jusqu'à 10 atomes de carbone.

6. Composition durcissable par une radiation selon la revendication 5, caractérisée en outre en ce que le composé organosilicié (A") est un silane ayant la formule générale

$$R_aSi(Y\text{-}O\text{-}CH{=}CHR")_{4-a} \qquad (iv)$$

dans laquelle R représente un groupe hydrocarboné ou hydrocarbonoxy monovalent ayant jusqu'à 18 atomes de carbone, R" représente un atome d'hydrogène d'un groupe alkyle monovalent ayant jusqu'à 10 atomes de carbone, Y représente un groupe hydrocarboné, hydrocarbonoxy ou polyoxyalkylène divalent et a a une valeur de 0 à 2.

7. Composition durcissable par une radiation selon la revendication 5, caractérisée en outre en ce que le composé organosilicié (A") est un siloxane ayant au moins une unité de la formule générale

$$R_cSi(Y\text{-}O\text{-}CH{=}CHR")_dO_{\frac{4-d-c}{2}} \qquad (v)$$

dans laquelle R, R" et Y sont tels que définis ci-dessus, d a une valeur de 1, 2 ou 3, c a une valeur de 0, 1 ou 2 et c+d a une valeur de 1 à 3, toute autre unité siloxane présente ayant la formule générale

$$R_bSiO_{\frac{4-b}{2}} \quad (vi)$$

dans laquelle b a une valeur de 0 à 3.

**8.** Composition durcissable par une radiation selon la revendication 7, caractérisée en outre en ce que le siloxane (A") a au moins deux unités de la formule générale (v), la valeur de d étant 1, est un organopolysiloxane substantiellement linéaire, dans laquelle la majorité des unités siloxanes ont la formule (vi) avec la valeur de b égale à 2.

**9.** Composition durcissable par une radiation selon l'une quelconque des revendications 3 à 8, caractérisée en ce que la quantité de catalyseur utilisée est dans la gamme de 0,5 à 10 % en poids sur la base du poids du composé (A).

**10.** Procédé de traitement d'un substrat, caractérisé en ce qu'il consiste à appliquer sur le substrat une composition selon l'une quelconque des revendications 3 à 9 et à durcir la composition en exposant le substrat traité à une radiation.

**11.** Substrat qui a été traité avec une composition selon l'une quelconque des revendications 3 à 9.